# EUROPEAN PATENT APPLICATION

(11) **EP 4 703 732 A1**
(43) Date of publication of application: **04.03.2026**
(21) Application number: 25162604.0
(22) Date of filing: 10.03.2025
(51) Int. Cl.: G01R 1/073, G01R 31/28

(54) **SUPPORTING STRUCTURE OF MEMBRANE PROBE CARD AND TEST METHOD OF MEMBRANE PROBE CARD**

(30) Priority: 30.08.2024 CN 202411215762
(71) Applicant: Xinger Technologies (Zhejiang) Limited, Yiwu, Jinhua (CN)
(72) Inventor: LOU, Choon Leong, 470605 SINGAPORE (SG)
(74) Representative: Michalski Hüttermann & Partner Patentanwälte mbB

(57) **Abstract**

The present disclosure provides a supporting structure of a membrane probe card. The supporting structure includes a frame body, a fixture, adjustment mechanisms, and first elastic structures. The frame body is configured to be in contact with the membrane. The fixture is configured to fixate the frame body on the substrate, and confine the frame body to be movable along a direction perpendicular to the substrate. The fixture includes through holes. The adjustment mechanisms are movably and tightly disposed in the through holes, respectively. The first elastic structures are disposed in a first space of the frame body, and each of the first elastic structures corresponds in position to one adjustment mechanism. The adjustment mechanisms are configured to adjust elastic forces of the first elastic structures.

## Description

### TECHNICAL FIELDF

The present disclosure relates to a membrane probe card and a test method for a membrane probe card, and more particularly to a membrane probe card with an adjustable supporting structure and a test method for the membrane probe card.

### DESCRIPTION OF THE PRIOR ART

An electrical test is an important step performed in the course of integrated circuit manufacturing to ensure normal device functioning. From the perspective of high-speed circuits nowadays, membrane probe cards are advantageously capable of performing high-frequency tests. However, membranes are not made of rigid materials, and in consequence the strength of the force of contact between each probe and a device under test (DUT) is uneven, thereby deteriorating the test quality.

Furthermore, the probe card or the DUT exhibits flatness that may vary. Alternatively, a force exerted on the probe card is uneven, and thus the membranes may differ in flatness. When the flatness of the membrane does not match the flatness of the DUT, the result of the electrical test is likely to be false.

Therefore, it is imperative to ensure the quality of contact between a thin film and a DUT.

The above description of the "prior art" merely serves to reveal background technology but is not intended to acknowledge that the above description of the "prior art" discloses the subject matters of the disclosure, constitutes the prior art of the disclosure, or is part of the disclosure.

### SUMMARY

In view of the aforesaid drawbacks of the prior art, it is an objective of the disclosure to provide a supporting structure of the membrane probe card and a test method for the membrane probe card.

An embodiment of the disclosure provides a supporting structure of a membrane probe card, with the supporting structure disposed between a substrate and a membrane fixed to the substrate to support a test area of the membrane. The supporting structure includes a frame body, a fixture, adjustment mechanisms and first elastic structures. The frame body is adapted to come into contact with the membrane. The fixture is adapted to fixate the frame body on the substrate and ensure that the frame body is movable in a direction perpendicular to the substrate. The fixture has a plurality of through holes. The adjustment mechanisms are movably and tightly disposed in the through holes, respectively. The first elastic structures are disposed in a first space of the frame body and correspond in position to the adjustment mechanisms, respectively. The adjustment mechanisms adjust elastic forces of the first elastic structures.

Another embodiment of the disclosure provides a test method for a membrane probe card, the membrane probe card comprising a substrate, a supporting structure and a membrane, with the supporting structure disposed between the substrate and the membrane to support a test area in the membrane. The test method includes the steps of: applying a first stress to the substrate to not only allow the test area of the membrane probe card to be in contact with a device under test but also allow a first contact stress to exist between the test area and the device under test; measuring a second stress between the supporting structure and the test area; adjusting an elastic force of at least one of a plurality of elastic structures in the supporting structure according to the second stress; and applying the first stress to the substrate to not only allow the test area of the membrane probe card to be in contact with the device under test but also allow a second contact stress to exist between the test area and the device under test. The second contact stress and the first contact stress are not equal.

Therefore, the disclosed supporting structure of the membrane probe card and the test method for the membrane probe card are effective in maintaining equal strength of force of contact between a membrane and a device under test and attaining reliable test results.

The technical features and advantages of the disclosure are described generally and extensively above to render the detailed description of the disclosure below comprehensible. Other technical features and advantages of the subject matters of the claims of the disclosure are described below. Persons skilled in the art understand that concepts and specific embodiments presented below can be easily used to amend or design any other structures or manufacturing processes and thereby achieve the same objective as the disclosure. Persons skilled in the art also understand that the aforesaid equivalent constructions cannot depart from the spirit and scope defined in the appended claims of the disclosure.

### BRIEF DESCRIPTION OF THE DRAWINGS

Persons skilled in the art can gain insight into the disclosure by referring to the embodiments, claims and drawings of the disclosure. In the drawings, like components are denoted by like reference numerals.
FIG. 1 is a schematic view of a test system according to some embodiments of the present disclosure.
FIG. 2 is a schematic view of a supporting structure according to some embodiments of the present disclosure.
FIG. 3 is a schematic view of how to test a device under test with a membrane probe card according to some embodiments of the present disclosure.
FIG. 4, FIG. 5 and FIG. 6 are schematic top views of arrangement of the supporting structures according to some embodiments of the present disclosure.
FIG. 7A and FIG. 7B are schematic top views of arrangement of adjustment mechanisms according to some embodiments of the present disclosure.
FIG. 8A and FIG. 8B are schematic top views of arrangement of the adjustment mechanisms according to some embodiments of the present disclosure.
FIG. 9A and FIG. 9B are schematic top views of arrangement of the adjustment mechanisms according to some embodiments of the present disclosure.
FIG. 10A and FIG. 10B are schematic top views of arrangement of the adjustment mechanisms according to some embodiments of the present disclosure.
FIG. 11A and FIG. 11B are schematic top views of arrangement of the adjustment mechanisms according to some embodiments of the present disclosure.
FIG. 12 is a schematic view of another test system according to other embodiments of the present disclosure.
FIG. 13 is a schematic view of the other test system according to other embodiments of the present disclosure.
FIG. 14 is a schematic view of the process flow of a test method according to some embodiments of the present disclosure.

### DETAILED DESCRIPTION

The description below is accompanied by drawings that are incorporated into and constitute a part of the specification to illustrate the embodiments of the disclosure. However, the disclosure is not limited to the embodiments. The embodiments described below may be appropriately integrated to attain any other embodiments.

The purpose of the expressions "an embodiment," "embodiment," "exemplary embodiment," "other embodiments" and "another embodiment" used herein is to state that the embodiments of the disclosure can include specific features, structures or characteristics. However, not every embodiment must include the specific features, structures or characteristics. Furthermore, repeated use of the expression "in an embodiment" does not necessarily imply referring to the same embodiment, as the possibility of referring to the same embodiment should not be ruled out.

The description below goes into detail about steps and structures in order for the disclosure to be fully comprehensible. Obviously, the embodiments of the disclosure do not place any limitations on specific details well known among persons skilled in the art. In addition, well-known structures and steps are not reiterated herein such that no limitations are unnecessarily placed on the disclosure. Preferred embodiments of the disclosure are described in detail below. However, in addition to the detailed description, the disclosure can be extensively implemented in other embodiments. The scope of the disclosure is defined by the appended claims rather than restricted to the detailed description.

The description below provides different embodiments or examples for use in implementing different features of the disclosure. Specific embodiments or examples of components and arrangements are described in detail herein to simplify the contents of the disclosure. The specific embodiments and examples are illustrative rather than restrictive of the disclosure. For instance, dimensions of components are not restricted to disclosed ranges or values but are based on process criteria and/or expected nature of devices. In the description below, an embodiment of forming a first feature on or above a second feature includes any embodiments in which the first and second features thus formed are in direct contact with each other or includes any embodiments in which an additional feature is formed between the first feature and the second feature, allowing the first and second features to be not in direct contact with each other. For the sake of conciseness and clarity, various features in the accompanying drawings are not drawn to scale. For the sake of conciseness, some layers/features are omitted from the accompanying drawings.

In addition, for explanatory purposes, expressions about spatial relationships, such as "beneath," "below," "lower," "above" and "upper," are used herein to explain the relationship between one component (or feature) and another component (or feature), as shown in the accompanying drawings. The expressions about spatial relationships are intended to indicate any other directions in which the components are used or operated in addition to the directions depicted in the accompanying drawings. The components may have any other directions (be rotated by 90 degrees or be aligned with another direction), and the expressions about spatial relationships can be construed accordingly.

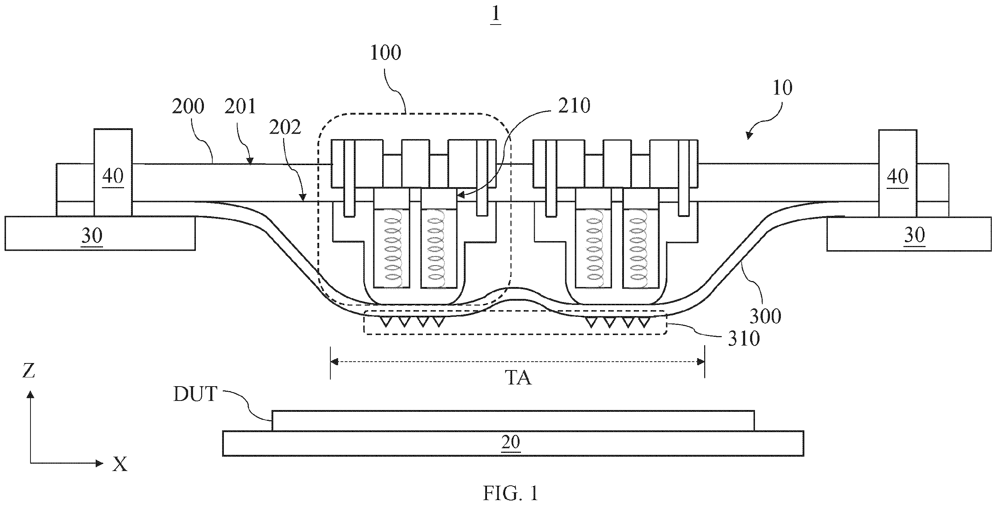

FIG. 1 is a schematic view of a test system 1 in some embodiments of the present disclosure. The test system 1 tests a device under test DUT. In some embodiments, the device under test DUT is an electronic device with contact points. In some embodiments, the device under test DUT is an integrated circuit on a die or a wafer-level integrated circuit. However, the present disclosure is not restricted thereto, as whatever electronic component capable of transmitting electrical signals can be the device under test DUT disclosed herein.

The test system 1 includes a membrane probe card 10, a carrier 20, a circuit board 30 and a connection structure 40. The carrier 20 carries the device under test DUT. The membrane probe card 10 is adapted to come into contact with the device under test DUT and send electronic signals, through the circuit board 30 and connection structure 40, to the device under test DUT to perform a test. For the sake of conciseness, FIG. 1 shows only one device under test DUT. However, the present disclosure is not limited thereto, as the membrane probe card 10 can test one or more device under test DUTs each time.

The membrane probe card 10 includes a supporting structure 100, a substrate 200 and a membrane 300. As shown in FIG. 1, two ends of the membrane 300 are fixed to the substrate 200, and the supporting structure 100 is disposed between the substrate 200 and the membrane 300 to support a test area TA of the membrane 300. The test area TA corresponds in position to the intended test area of the device under test DUT. Different test areas TA correspond in position to different devices under test DUT, respectively. The test area TA can be adaptively adjusted according to the device under test DUT. For instance, one test area TA corresponds in position to one or more devices under test DUT.

As shown in FIG. 1, the membrane 300 is fixed onto a second surface 202 of the substrate 200. In various embodiments, the membrane 300 is fixed onto a first surface 201 of the substrate 200. The first surface 201 and the second surface 202 face away from each other.

The membrane probe card 10 has probes 310 disposed within the test area TA of the membrane 300. After the membrane probe card 10 has come into contact with the device under test DUT, the probes 310 are in direct contact with electronic contact points of the device under test DUT. The membrane 300 further has path lines whereby electronic signals are transmitted between the circuit board 30 and/or the connection structure 40 and the probes 310.

The membrane is made of a flexible material. As disclosed in prior art, with tolerance existing in the flatness of the probe card or the device under test, the strengths of the contact forces exerted by the probes on the devices under test respectively are not equal and, as a result, may be either insufficient or excessive. Insufficient strength of the contact force leads to the poor quality of contact between the probe and the device under test and the resultant excessive impedance in signal transmission or even an open circuit. Excessive strength of the contact force either causes the probe to destroy a contact point of the device under test or causes damage to the probe. If the destroyed contact point of the device under test is a bump and the device under test has to undergo a subsequent reflow process, the destroyed bump is likely to generate bubbles and reduce the electrical properties of the bump. All the aforesaid events have a negative effect on the test results.

Compared with the prior art, the embodiments of the present disclosure provide an elastic adjustable supporting structure 100, and the elastic force of the supporting structure 100 can be adjusted in order to adjust the pre-force exerted on the test area TA of the membrane at different points and thereby compensate for the phenomenon of uneven contact stress. Furthermore, although the uneven flatness of the membrane probe card 10 or the device under test DUT leads to unsatisfactory test results, the flatness of the membrane probe card 10 or the device under test DUT becomes consistent after the strength of contact force has been adjusted to become uniform.

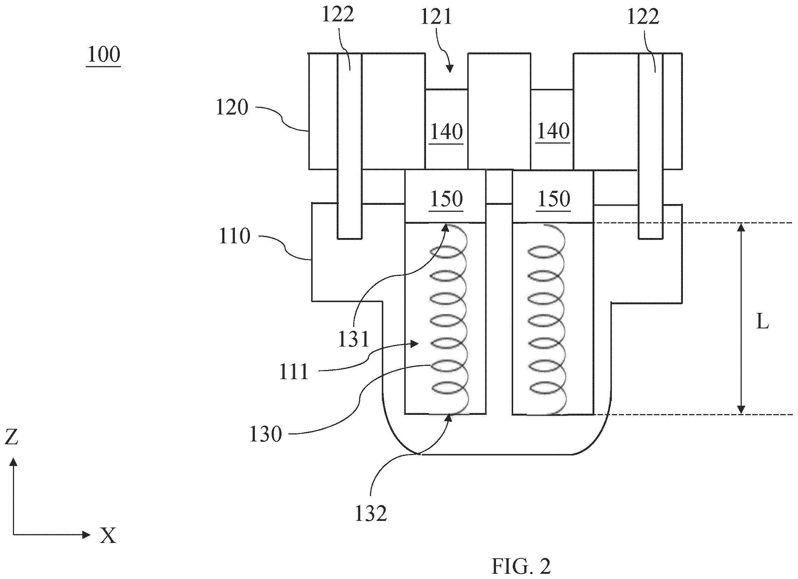

Referring to FIG. 2, there is shown a schematic view of the supporting structure 100 in some embodiments of the present disclosure. The supporting structure 100 includes a frame body 110, a fixture 120, elastic structures 130, adjustment mechanisms 140 and plates 150. The fixture 120 is disposed on the first surface 201 of the substrate 200, and the frame body 110 is disposed on the second surface 202 of the substrate 200. The fixture 120 fixates the frame body 110 on the substrate 200 with screws.

The frame body 110 has spaces 111 therein for receiving the elastic structures 130 respectively as shown in FIG. 2.

The fixture 120 has through holes 121. The substrate 200 has through holes 210 (shown in FIG. 1). The through holes 121 of the fixture 120 correspond in position to the through holes 210 of the substrate 200 respectively; thus, when the fixture 120 is disposed on the substrate 200, the through holes 121 of the fixture 120 and the through holes 210 of the substrate 200 jointly form continuous through holes. In an embodiment, position-limiting posts 122 are disposed between the fixture 120 and the frame body 110 to allow the frame body 110 to move upward and downward in the direction perpendicular to the substrate 200 (i.e., in Z-direction) rather than move in X-, Y-directions or rotate about an axis extending in X-, Y-directions.

The adjustment mechanisms 140 are movably and tightly disposed in the through holes 121 of the fixture 120 respectively. The plates 150 are each disposed between one of the adjustment mechanisms 140 and a corresponding one of the elastic structures 130. Each of the adjustment mechanisms 140 has one end in contact with one end of a corresponding one of the plates 150. The other end of the plate 150 is connected to a first end 131 of a corresponding one of the elastic structures 130. A second end 132 of the elastic structure 130 is connected to the frame body 110.

In some embodiments, the adjustment mechanisms 140 are screws. The through holes 121 of the fixture 120 have threads. The adjustment mechanisms 140 engage with the threads and rotate relative to the threads to move upward and downward (i.e., in Z-direction), causing the plates 150 to move upward and downward. Since the first ends 131 of the elastic structures 130 are connected to the plates 150, the positions of the first ends 131 of the elastic structures 130 change whenever the adjustment mechanisms 140 move upward and downward within the through holes 121.

In some embodiments, the elastic structures 130 are springs. When a length L between the first end 131 and the second end 132 of each of the elastic structures 130 changes, under Hooke's law (F=-x·κ), an elastic force (F) of each of the elastic structures 130 changes with a change (x) in length L, where κ denotes a spring constant. When the adjustment mechanisms 140 move to different positions, the elastic structures 130 have different elastic forces. Thus, the adjustment mechanisms 140 adjust the elastic forces of the elastic structures 130.

In some embodiments, the frame body 110 is in contact with the membrane 300, and the elastic forces of the elastic structures 130 in the frame body 110 affect the contact stress of each of the probes 310 in contact with a corresponding one of the devices under test DUT. Therefore, the contact stress of each of the probes 310 in contact with a corresponding one of the devices under test DUT can be adjusted according to the changes in the positions of the adjustment mechanisms 140. In some embodiments, the frame body 110 corresponds in position to one or more devices under test DUT.

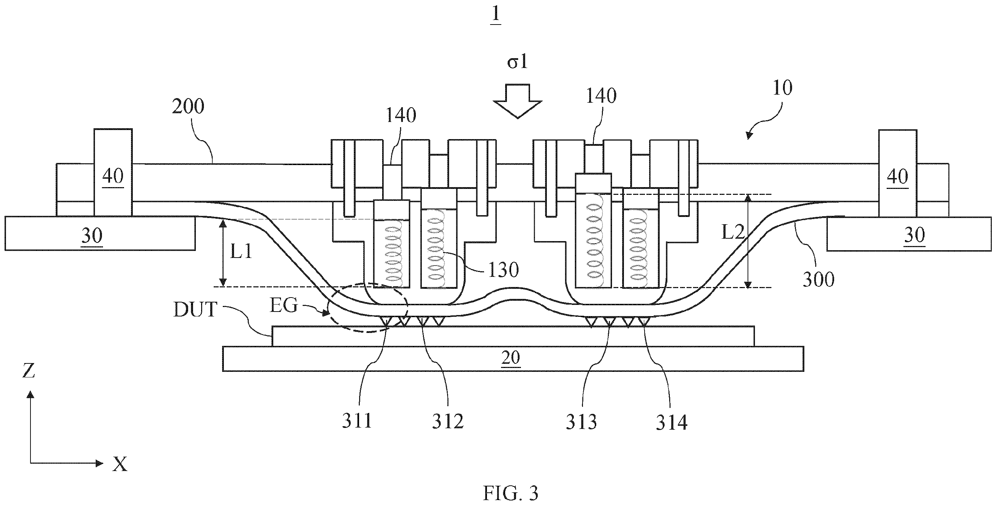

Referring to FIG. 3, there is shown a schematic view of how to test the device under test DUT with the membrane probe card 10 in some embodiments of the present disclosure. When a stress σ1 is exerted on the substrate 200, an edge EG of the test area TA bends after the probe 310 has come into contact with the device under test DUT; thus, owing to the bending of the edge EG, a probe 311 and a probe 312 in contact with respective device under test DUT differ in terms of contact stress. With the contact stresses being not equal, the flatness of the thin film 300 within the test area TA is not consistent. For instance, the probe 311 near the edge EG is positioned distal to the device under test DUT, and thus the contact stress between the probe 311 and the device under test DUT is less than the contact stress between the probe 312 and the device under test DUT. To compensate for the difference in the contact stress, the adjustment mechanisms 140 near the edge EG are adjusted to be positioned lower in order to compress the elastic structures 130; thus, the length L is shortened to become length L1, and in consequence that the elastic structures 130 exert greater elastic forces on the thin film 300, increasing the contact stress between the probe 311 and the device under test DUT. The increase in the contact stress between the probe 311 and the device under test DUT not only brings about an improvement in the evenness of the contact stress between the probe 311 and the device under test DUT and the contact stress between the probe 312 and the device under test DUT but also causes the flatness of the membrane 300 at the probe 311 to approximate to the flatness of the thin film 300 at the probe 312 (i.e., enhancing the evenness of the flatness of the membrane 300). In some embodiments, upon the adjustment of the elastic force of the elastic structure 130 corresponding in position to the probe 311, the elastic force of the elastic structure 130 corresponding in position to the probe 311 is not equal to the elastic force of the elastic structure 130 corresponding in position to the probe 312 when the probe 311 and the probe 312 are in contact with the device under test DUT. In some embodiments, upon the adjustment of the elastic force of the elastic structure 130 corresponding in position to the probe 311, the contact stress between the probe 311 and the device under test DUT and the contact stress between the probe 312 and the device under test DUT are substantially equal when the probe 311 and the probe 312 are in contact with the device under test DUT. In some embodiments, upon the adjustment of the elastic force of the elastic structure 130 corresponding in position to the probe 311, the predetermined flatness within the test area TA can be maintained when the probe 311 and the probe 312 are in contact with the device under test DUT.

In some embodiments, the surface of the device under test DUT has a contact point corresponding in position to a probe 313 which is higher (in Z-direction) than a contact point of the device under test DUT corresponding in position to a probe 314, whereas the contact stress between the probe 313 and the device under test DUT is greater than the contact stress between the probe 314 and the device under test DUT when the probe 313 and the probe 314 are in contact with the device under test DUT. To compensate for the difference in contact stress, the adjustment mechanism 140 corresponding in position to the probe 314 is adjusted to be positioned higher in order to stretch the corresponding elastic structure 130; thus, the length L is lengthened to become a length L2, and in consequence the corresponding elastic structure 130 exerts a weaker elastic force on the membrane 300, decreasing the contact stress between the probe 313 and the device under test DUT. The decrease in the contact stress between the probe 313 and the device under test DUT not only brings about an improvement in the evenness of the contact stress between the probe 313 and the device under test DUT and the contact stress between the probe 314 and the device under test DUT but also causes the flatness of the membrane 300 at the probe 313 to approximate to the flatness of the membrane 300 at the probe 314 (i.e., enhancing the evenness of the flatness of the membrane 300). In some embodiments, upon the adjustment of the elastic force of the elastic structure 130 corresponding in position to the probe 313, the elastic force of the elastic structure 130 corresponding in position to the probe 313 is not equal to the elastic force of the elastic structure 130 corresponding in position to the probe 314 when the probe 313 and the probe 314 are in contact with the device under test DUT. In some embodiments, upon the adjustment of the elastic force of the elastic structure 130 corresponding in position to the probe 313, the contact stress between the probe 313 and the device under test DUT is substantially equal to the contact stress between the probe 314 and the device under test DUT when the probe 313 and the probe 314 are in contact with the device under test DUT. In some embodiments, upon the adjustment of the elastic force of the elastic structure 130 corresponding in position to the probe 313, the predetermined flatness within the test area TA can be maintained when the probe 313 and the probe 314 are in contact with the device under test DUT.

Therefore, the adjustment of the elastic forces of the elastic structures 130 is followed by the application of stress σ1 to the substrate 200 to allow the probes 310 to come into contact with the device under test DUT respectively, not only allowing the contact stress between each of the probes 311-314 and the device under test DUT to be more uniform, but also allowing the membrane 300 to have appropriate flatness for testing the device under test DUT. In some embodiments, the contact stress between each of the probes 311-314 and the device under test DUT are substantially the same.

In other embodiments, the adjusted elastic forces of the elastic structures 130 are equal to the unadjusted elastic forces of the elastic structures 130.

In other embodiments, the adjusted contact stress of the probes corresponding in position to the elastic structures 130 is not equal to the unadjusted contact stress of the probes corresponding in position to the elastic structures 130.

In some embodiments, the membrane probe card 10 includes supporting structures 100, and the elastic structures 130 in each of the supporting structures 100 are identical or different. For instance, in some embodiments, springs with different diameters or different wire diameters for use in the supporting structures 100 vary from supporting structure to supporting structure. In other embodiments, the same supporting structure 100 uses springs with different diameters or different wire diameters. Thus, the spring constant κ of the elastic structures 130 in each of the supporting structures 100 is the same or different.

As shown in FIG. 1, FIG. 2 and FIG. 3, each of the supporting structures 100 includes two adjustment mechanisms 140 and two spaces 111 for containing two elastic structures 130. However, the present disclosure is not limited thereto, as the adjustment mechanisms 140, the spaces 111 and the elastic structures 130 can be in any numbers and still fall within the scope of the present disclosure.

In some embodiments, each of the adjustment mechanisms 140 adjusts one elastic structure 130, and each of the elastic structures 130 corresponds in position to a corresponding one of the probes 310. In some embodiments, one of the adjustment mechanisms 140 adjusts at least two elastic structures 130, and one of the elastic structures 130 corresponds in position to a corresponding one of the probes 310. In some embodiments, one of the adjustment mechanisms 140 adjusts at least two elastic structures 130, and one of the elastic structures 130 corresponds in position to at least two probes 310.

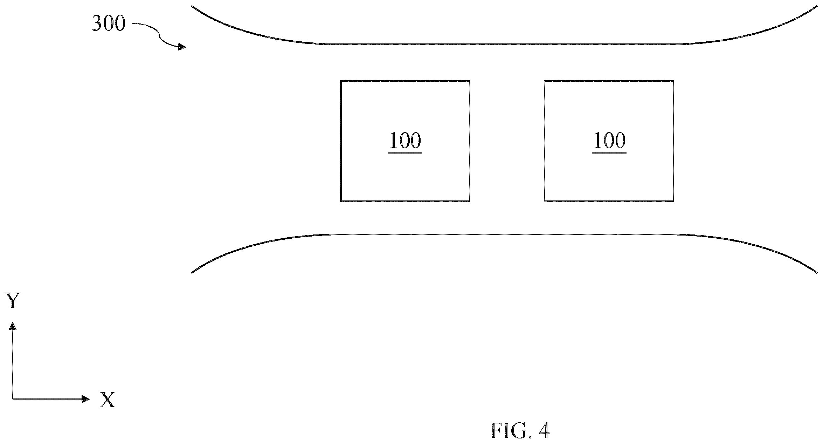

Referring to FIG. 4, FIG. 5 and FIG. 6, there are shown schematic top views of arrangement of the supporting structures 100 in some embodiments of the present disclosure. For the sake of easy comprehension, FIG. 4, FIG. 5 and FIG. 6 merely show relative positions of the membrane 300 and the supporting structures 100.

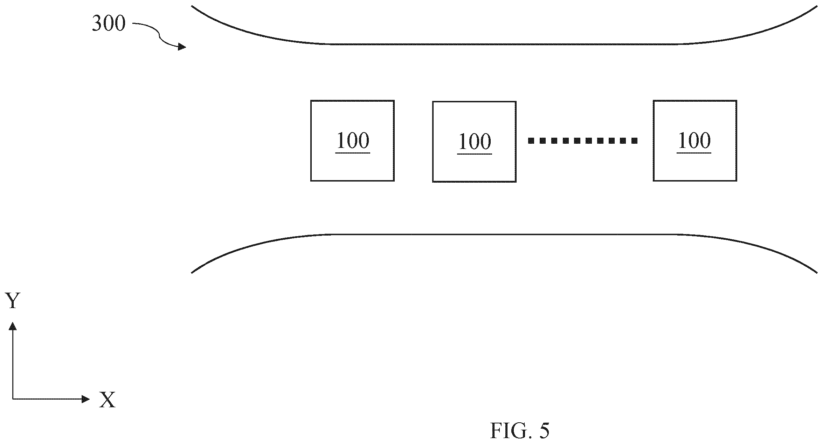

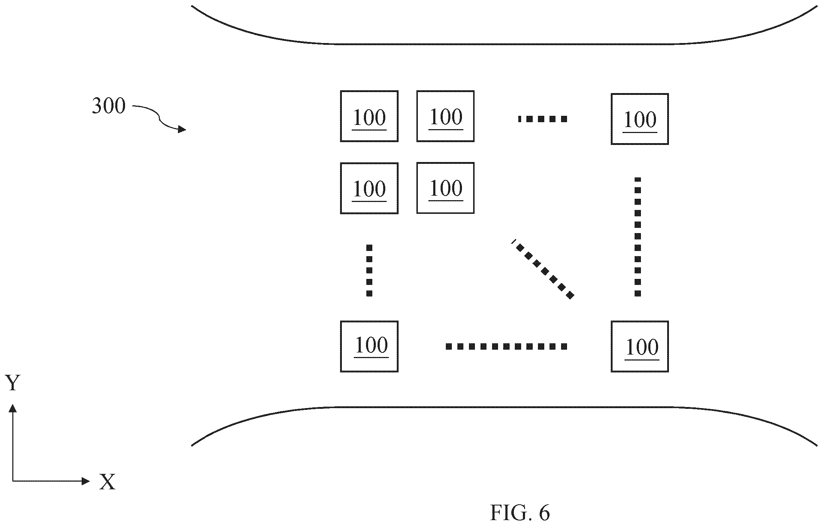

In an embodiment illustrated by FIG. 4, the membrane probe card 10 includes two supporting structures 100 aligned in the primary dimension of the membrane 300 (for example, X-direction). In an embodiment illustrated by FIG. 5, the membrane probe card 10 includes at least two supporting structures 100 aligned in a straight line extending in the primary dimension of the membrane 300 (for example, X-direction). In an embodiment illustrated by FIG. 6, the membrane probe card 10 includes the supporting structures 100 arranged in a matrix.

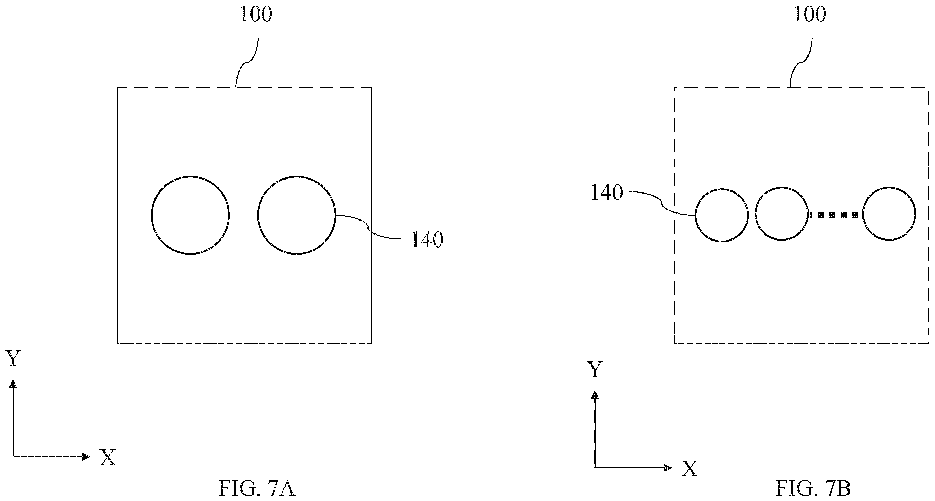

Referring to FIG. 7A and FIG. 7B, there are shown schematic top views of arrangement of the adjustment mechanisms 140 in some embodiments of the present disclosure. In an embodiment illustrated by FIG. 7A, the supporting structure 100 includes two adjustment mechanisms 140 aligned in a straight line extending in X-direction. In an embodiment illustrated by FIG. 7B, the supporting structure 100 includes at least two adjustment mechanisms 140 aligned in a straight line extending in X-direction.

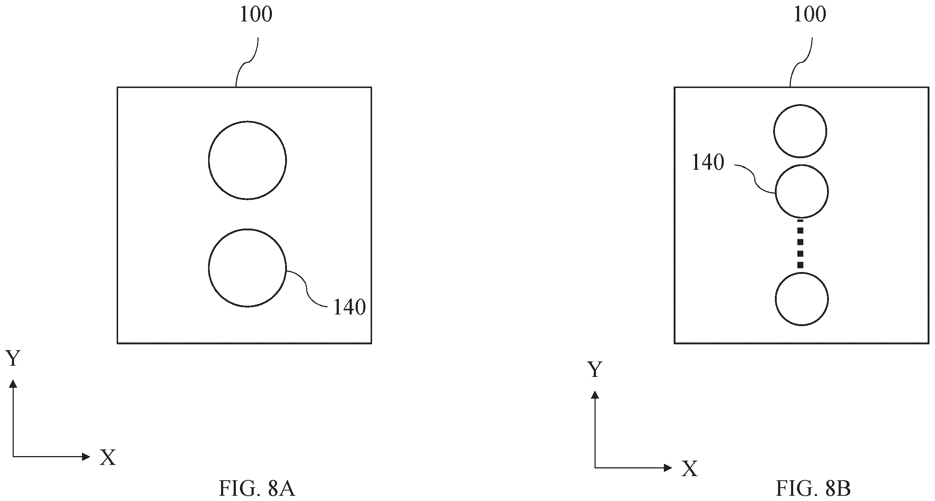

Referring to FIG. 8A and FIG. 8B, there are shown schematic top views of arrangement of the adjustment mechanisms 140 in some embodiments of the present disclosure. In an embodiment illustrated by FIG. 8A, the supporting structure 100 includes two adjustment mechanisms 140 aligned in a straight line extending in Y-direction, with Y-direction being perpendicular to X-direction. In an embodiment illustrated by FIG. 8B, the supporting structure 100 includes at least two adjustment mechanisms 140 aligned in a straight line extending in Y-direction.

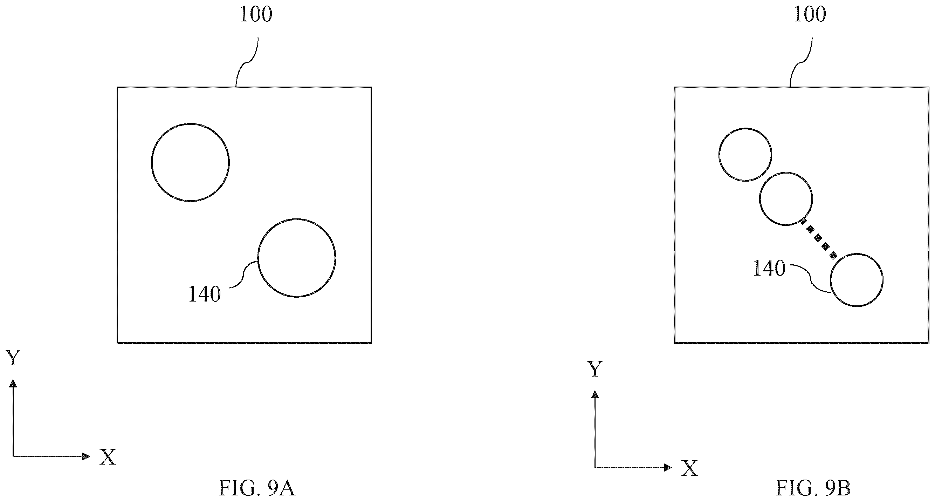

Referring to FIG. 9A and FIG. 9B, there are shown schematic top views of arrangement of the adjustment mechanisms 140 in some embodiments of the present disclosure. In an embodiment illustrated by FIG. 9A, the supporting structure 100 includes two adjustment mechanisms 140 aligned in a straight line extending in one direction, with the direction not being parallel to X-direction and Y-direction. In an embodiment illustrated by FIG. 9B, the supporting structure 100 includes at least two adjustment mechanisms 140 aligned in a straight line extending in one direction, with the direction not being parallel to X-direction and Y-direction.

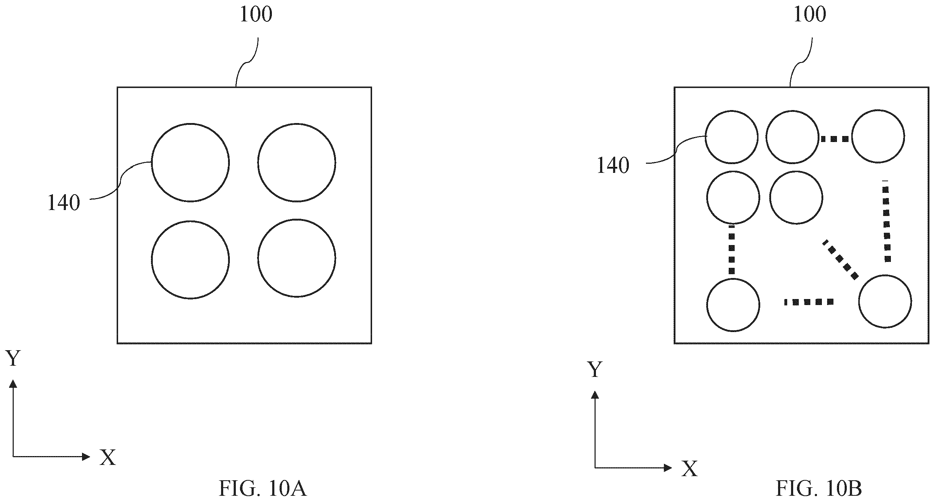

Referring to FIG. 10A and FIG. 10B, there are shown schematic top views of arrangement of the adjustment mechanisms 140 in some embodiments of the present disclosure. In an embodiment illustrated by FIG. 10A, the supporting structure 100 includes four adjustment mechanisms 140 arranged in a 2X2 matrix. In an embodiment illustrated by FIG. 10B, the supporting structure 100 includes at least four adjustment mechanisms 140 arranged in an N×M matrix, where N and M are positive integers.

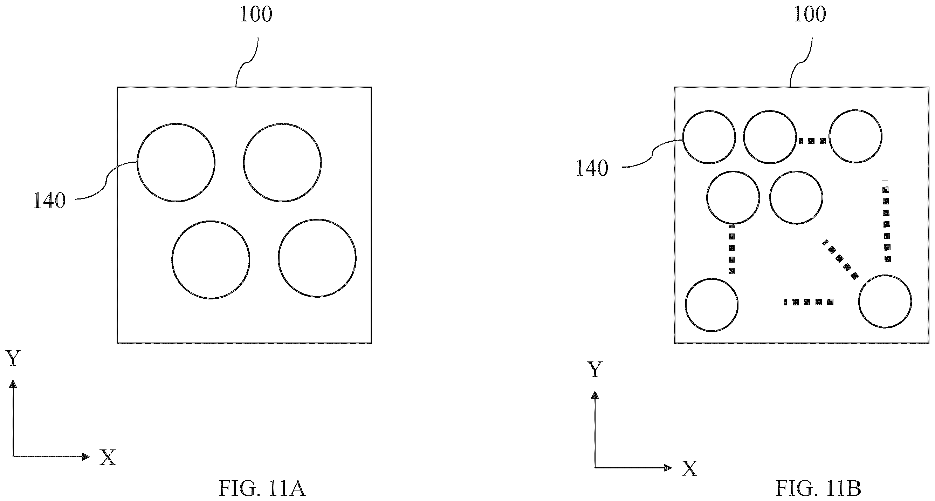

Referring to FIG. 11A and FIG. 11B, there are shown schematic top views of arrangement of the adjustment mechanisms 140 in some embodiments of the present disclosure. In an embodiment illustrated by FIG. 11A, the supporting structure 100 includes four adjustment mechanisms 140 arranged in two rows in such a manner that the adjustment mechanisms 140 of the first row are staggered relative to the adjustment mechanisms 140 of the second row in Y-direction. In an embodiment illustrated by FIG. 11B, the supporting structure 100 includes at least four adjustment mechanisms 140 arranged in multiple rows in such a manner that the adjustment mechanisms 140 of any two adjacent rows are in a staggered arrangement in Y-direction.

In the embodiments illustrated by FIG. 10A, FIG. 10B, FIG. 11A and FIG. 11B, the adjustment mechanisms 140 in each row are equidistant.

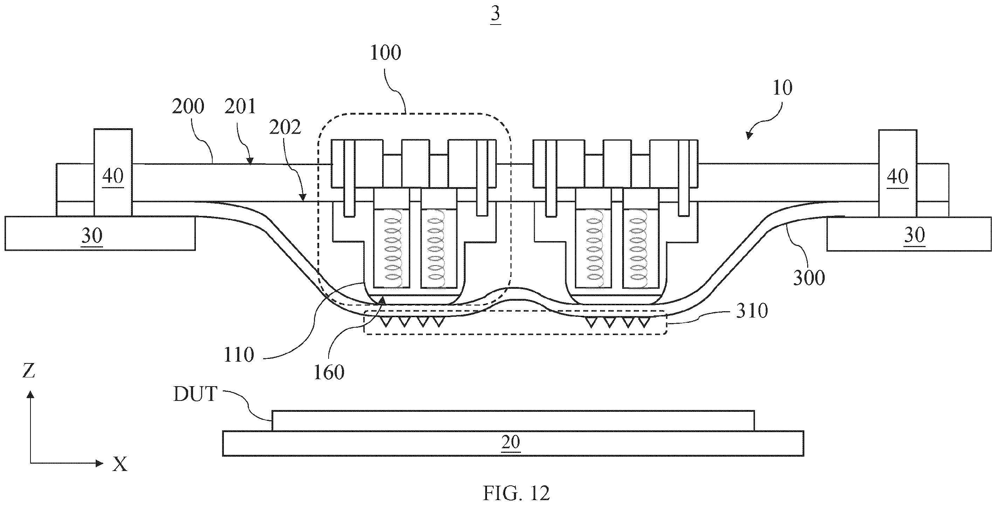

FIG. 12 is a schematic view of a test system 2 according to other embodiments of the present disclosure. The test system 2 is similar to the test system 1, except that in the test system 2 the supporting structures 100 each includes an elastomer 160 disposed between the frame body 110 and the membrane 300, with the elastomer 160 being in direct contact with the membrane 300 and the frame body 110. The elastomers 160 provide additional buffer to the membrane 300 and the frame body 110.

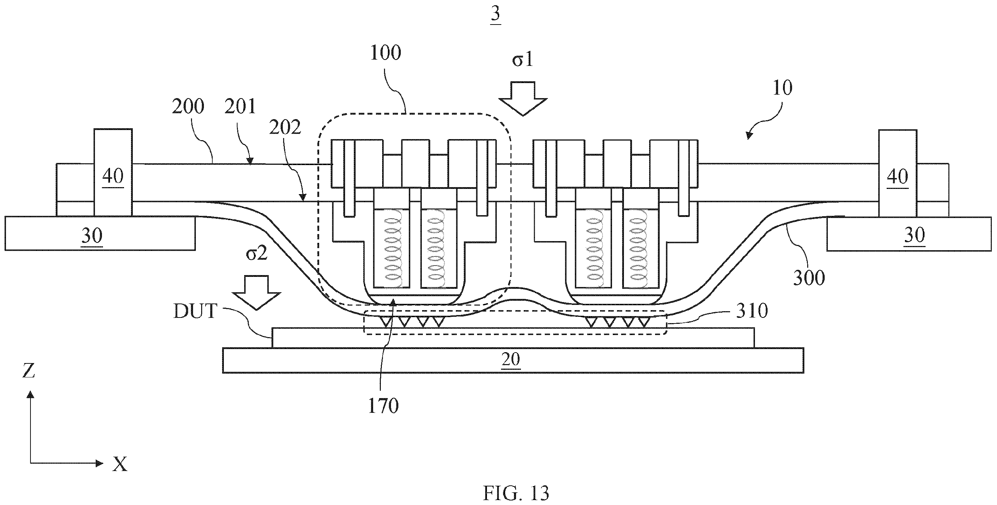

FIG. 13 is a schematic view of a test system 3 according to other embodiments of the present disclosure. The test system 3 is similar to the test system 1, except that in the test system 3 the supporting structures 100 each includes a pressure sensor 170. The pressure sensors 170 measure a stress σ2 between the frame body 110 and the membrane 300. The adjustment mechanisms 140 adjust the elastic forces of the elastic structures 130 according to the stress σ2 measured with the pressure sensors 170. For instance, when the stress σ2 measured by the pressure sensors 170 is greater than a first threshold, the corresponding one of the adjustment mechanisms 140 reduces the elastic force of the corresponding one of the elastic structures 130. Alternatively, when the stress σ2 measured by the pressure sensors 170 is lower than a second threshold, the corresponding one of the adjustment mechanisms 140 increases the elastic force of the corresponding one of the elastic structures 130, where the first threshold is greater than the second threshold.

In some embodiments, the test system 1 includes the elastomers 160 of the test system 2 and the pressure sensors 170 of the test system 3.

In other embodiments, the stress σ2 of the test system 1 and/or test system 2 is measured by external pressure sensors. Before a process of testing the device under test DUT begins, the probes 310 of the test system 1 and/or test system 2 press against the external pressure sensors, and then the adjustment mechanisms 140 are adjusted according to the stress σ2 measured by the external pressure sensors to allow the probes 310 to achieve the intended contact stress. Upon completion of the adjustment, the process of testing the device under test DUT begins.

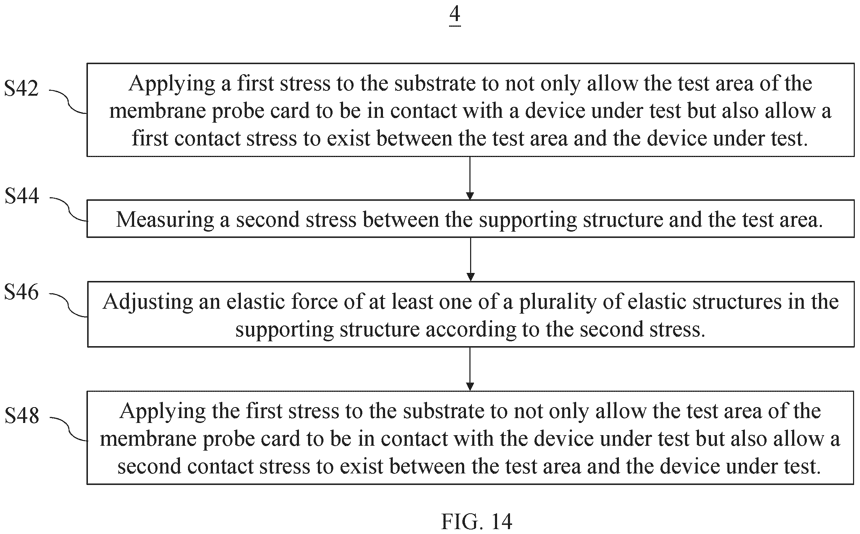

Referring to FIG. 14, there is shown a schematic view of the process flow of a test method 4 according to some embodiments of the present disclosure. In some embodiments, the test system 1, test system 2 and/or test system 3 perform the test method 4 to conduct a test on the device under test DUT. For the sake of easy comprehension, the reference numerals for use with the test system 1, test system 2 and test system 3 are also applicable to the test method 4.

The test method 4 includes a step S42, a step S44, a step S46 and a step S48. Step S42 entails applying the first stress σ1 to the substrate 200 to not only allow the test area TA of the membrane probe card 10 to come into contact with the device under test DUT but also allow the test area TA to have a first flatness. Step S44 entails measuring a second stress σ2 between the supporting structure 100 and the test area TA. Step S46 entails adjusting the elastic force of at least one of the elastic structures 130 in the supporting structure 100 according to the second stress σ2. Step S48 entails applying the first stress σ1 to the substrate 200 to not only allow the test area TA of the membrane probe card 10 to come into contact with the device under test DUT but also allow the test area TA to have a second flatness.

Step S42, step S44, step S46 and step S48 are not restrictive of the test method 4 of the disclosure. All various operations described in the embodiments illustrated by FIG. 1 through FIG. 13 shall fall within the scope of the test method 4 and considerations given thereto.

In conclusion, a supporting structure of a membrane probe card and a test method for the membrane probe card, as provided in the embodiments of the present disclosure, are effective in adjusting the stress between a membrane and a device under test with elastic structures in the supporting structure and thereby controlling flatness of the membrane. Therefore, the present disclosure optimizes the electrical contact between the device under test and each of a corresponding one of the probes on the membrane to enhance test precision and protect the probe card and the device under test against damage.

Although the disclosure and advantages thereof are described in detail above, persons skilled in the art understand that various changes, replacements and substitutions may be made to the disclosure without departing from the spirit and scope defined in the appended claims of the disclosure. For instance, the aforesaid processes may be implemented with different methods and replaced with any other processes or a combination thereof.

The scope of the disclosure is not restricted to specific embodiments of any processes, machines, manufacturing, matter compositions, means, methods and steps described herein. The disclosure described herein enables persons skilled in the art to implement the disclosure with any existing or potential processes, machines, manufacturing, matter compositions, means, methods or steps having the same function or capable of achieving substantially the same result as disclosed in the aforesaid embodiments. Therefore, these processes, machines, manufacturing, matter compositions, means, methods and steps fall within the scope of the appended claims of the disclosure.

## Claims

1. A supporting structure of a membrane probe card, wherein the supporting structure is disposed between a substrate and a membrane fixed to the substrate to support a test area of the membrane, the supporting structure comprising:
a frame body, configured to contact with the membrane;
a fixture, configured to fixate the frame body on the substrate and confine the frame body to be movable along a direction perpendicular to the substrate, wherein the fixture has a plurality of through holes;
a plurality of adjustment mechanisms, movably and tightly disposed in the through holes, respectively; and
a plurality of first elastic structures, disposed in a first space of the frame body and corresponding in position to the adjustment mechanisms, respectively,
wherein the adjustment mechanisms are configured to adjust elastic forces of the first elastic structures.

2. The supporting structure of claim 1, further comprising:
a plurality of plates, each disposed between a corresponding one of the adjustment mechanisms and a corresponding one of the first elastic structures.

3. The supporting structure of claim 2, wherein the first elastic structures each comprises:
a first end, in contact with a corresponding one of the plates; and
a second end, in contact with the frame body,
wherein the first elastic structures are springs, and a distance between the first end and the second end correlates with elastic forces of the first elastic structures, wherein the adjustment mechanisms are configured to adjust positions of the plates so as to adjust the distance between the first end and the second end.

4. The supporting structure of claim 1, wherein the through holes have threads, and the adjustment mechanisms are screws engaging with the threads and rotate relative to the threads to move in the direction perpendicular to the substrate.

5. The supporting structure of claim 1, wherein each of the adjustment mechanisms is configured to adjust the elastic force of the corresponding one of the first elastic structures, wherein the elastic forces of the first elastic structures being adjusted make probes of the membrane have equalized contact stress to a device under test.

6. The supporting structure of claim 1, wherein the elastic forces of the first elastic structures being adjusted make the test area of the membrane be kept at a predetermined flatness.

7. The supporting structure of claim 1, further comprising:
a plurality of second elastic structures, disposed in a second space of the frame body and corresponding in position to the adjustment mechanisms, respectively,
wherein the adjustment mechanisms are configured to adjust elastic forces of the second elastic structures, respectively.

8. The supporting structure of claim 7, wherein the adjusted elastic forces of the second elastic structures being adjusted make probes of the membrane have equalized contact stress to a device under test.

9. The supporting structure of claim 8, wherein the elastic forces of the first elastic structures being adjusted are equal to or not equal to the elastic forces of the second elastic structures being adjusted.

10. The supporting structure of claim 7, wherein the membrane comprises a plurality of probes thereon, wherein the second elastic structures each corresponds in position to at least one of the probes, and the elastic forces of the second elastic structures being adjusted cause a contact stress exerted by at least one of the probes on a device under test to be not equal to a contact stress exerted by at least another one of the probes on the device under test.

11. The supporting structure of claim 1, wherein, from a top-view perspective, the adjustment mechanisms are arranged in an N×M matrix, where N and M are positive integers.

12. The supporting structure of claim 1, wherein, from a top-view perspective, the adjustment mechanisms are arranged in a plurality of rows each extending in a first direction, wherein the adjustment mechanisms in each one of the rows are equidistant, and the adjustment mechanisms arranged in any two adjacent ones of the rows are in a staggered arrangement in a second direction, with the first direction being perpendicular to the second direction.

13. The supporting structure of claim 1, further comprising:
an elastomer, disposed between the frame body and the membrane.

14. The supporting structure of claim 1, further comprising:
a pressure sensor, configured to measure a second stress between the frame body and the membrane,
wherein the adjustment mechanisms adjust the elastic forces of the first elastic structures according to the second stress.

15. A test method for a membrane probe card, wherein the membrane probe card comprising a substrate, a supporting structure and a membrane, wherein the supporting structure is disposed between the substrate and the membrane and configured to support a test area in the membrane, the test method comprising the steps of:
applying a first stress to the substrate to not only allow the test area of the membrane probe card to be in contact with a device under test but also allow a first contact stress to exist between the test area and the device under test;
measuring a second stress between the supporting structure and the test area;
adjusting an elastic force of at least one of a plurality of elastic structures in the supporting structure according to the second stress; and
applying the first stress to the substrate to not only allow the test area of the membrane probe card to be in contact with the device under test but also allow a second contact stress to exist between the test area and the device under test,
wherein the second contact stress and the first contact stress are not equal.
